# FASCICULE DE BREVET EUROPEEN

(11) **EP 2 852 846 B1**
(45) Date de publication et mention de la délivrance du brevet: **24.08.2016**
(21) Numéro de dépôt: 13709225.0
(22) Date de dépôt: 15.03.2013
(51) Int. Cl.: G01R 31/3177, G01R 31/317, G01R 31/3185, G01R 31/3181

(54) **DISPOSITIF DE TEST ET DE SURVEILLANCE OU MONITORING DE CIRCUITS NUMERIQUES**
VORRICHTUNG ZUM PRÜFEN UND ÜBERWACHEN DIGITALER SCHALTUNGEN
DEVICE FOR TESTING AND MONITORING DIGITAL CIRCUITS

(30) Priorité: 21.05.2012 FR 1254611
(43) Date de publication de la demande: 01.04.2015
(73) Titulaire: Commissariat à l'Énergie Atomique et aux Énergies Alternatives, 75015 Paris (FR)
(72) Inventeur: GHERMAN, Valentin, F-91120 Palaiseau (FR)
(74) Mandataire: Dudouit, Isabelle
(86) Numéro de dépôt international: PCT/EP2013/055336
(87) Numéro de publication internationale: WO 2013/174535

(56) Documents cités:
- US-A1- 2011 022 909
- YANAGAWA Y ET AL: "Experimental Verification of Scan-Architecture-Based Evaluation Technique of SET and SEU Soft-Error Rates at Each Flip-Flop in Logic VLSI Systems", IEEE TRANSACTIONS ON NUCLEAR SCIENCE, IEEE SERVICE CENTER, NEW YORK, NY, US, vol. 56, no. 4, 1 août 2009 (2009-08-01), pages 1958-1963, XP011272192, ISSN: 0018-9499, DOI: 10.1109/TNS.2009.2020166
- KEE SUP KIM ET AL: "Robust System Design with Built-In Soft-Error Resilience", COMPUTER, IEEE SERVICE CENTER, LOS ALAMITOS, CA, US, vol. 38, no. 2, 1 février 2005 (2005-02-01), pages 43-52, XP011127453, ISSN: 0018-9162, DOI: 10.1109/MC.2005.70 cité dans la demande
- YANAGAWA Y ET AL: "Scan-Architecture-Based Evaluation Technique of SET and SEU Soft-Error Rates at Each Flip-Flop in Logic VLSI Systems", IEEE TRANSACTIONS ON NUCLEAR SCIENCE, IEEE SERVICE CENTER, NEW YORK, NY, US, vol. 34, no. 4, 1 août 2008 (2008-08-01), pages 1947-1952, XP011235512, ISSN: 0018-9499

## Description

L'objet de l'invention concerne un dispositif pour le test et le monitoring de circuits numériques séquentiels, le dispositif étant inséré, par exemple, dans une chaîne d'observation et contrôle ou « chaîne de scan », avec un impact minimal sur la latence de ces circuits. Les dispositifs selon l'invention permettent d'éviter l'utilisation des bascules scan standard, connues de l'Homme du métier, sur des chemins critiques.

L'expression « chemin critique » dans la présente description désigne un chemin électrique entre une bascule ou une entrée primaire et une autre bascule ou une sortie primaire qui se distingue par le fait que la latence de propagation des signaux électriques qui parcourent le chemin correspond à une des plus grandes latences qui caractérisent les chemins électriques d'un circuit (entre une bascule ou une entrée primaire et une autre bascule ou une sortie primaire).

Les circuits réalisés à base de micro et de nanotechnologies peuvent être affectés par des fautes qui sont générées, par exemple, par des défauts physiques résultant du procédé de fabrication ou du processus de vieillissement, par une inadaptation de la fréquence d'horloge du circuit à la tension d'alimentation, et/ou par des variations de la température ou de la tension d'alimentation. Ces fautes peuvent engendrer des erreurs de fonctionnement et finalement la défaillance des systèmes dans lesquels ces circuits sont utilisés.

Les défauts physiques introduits dans les circuits lors du processus de fabrication peuvent être identifiés à l'aide de tests de fabrication. La capacité à détecter ces défauts peut être augmentée de façon significative en utilisant des solutions de conception en vue du test offrant la possibilité de configurer une partie ou toutes les bascules des circuits en chaînes de scan pendant le test. Un exemple est donnée dans les pages 366-368 du livre de M. Abramovici, M.A. Breuer, A.D. Friedman « Digital Systems Testing and Testable Design », IEEE Press, 1990.

En ce qui concerne les autres sources de défaillance, elles se manifestent généralement par des fautes de délai. Une des approches les plus efficaces de prévention de ces défaillances est de détecter les éventuelles fautes de délai avant qu'elles ne génèrent des erreurs. Parmi ce type de solutions connues de l'Homme du métier, certaines techniques de monitoring offrent une détection en ligne des fautes de délai en effectuant un double échantillonnage des signaux sur les chemins critiques.

Une de ces solutions repose sur l'utilisation d'un élément de délai, par exemple un « Buffer », d'éléments d'échantillonnage à l'entrée et à la sortie de l'élément de délai, et d'un élément de comparaison entre les sorties des éléments d'échantillonnage. Des exemples de cette méthode sont décrits, par exemple, dans la publication de S. Mitra, N. Siefert, M. Zhang, Q. Shi, K.S. Kim "Robust system design with built-in soft-error resilience," IEEE Computer, Spécial Issue on Nano-Scale Design and Test, 38(2), pp. 43-52, 2005 ou celle de M. Nicolaidis "Time redundancy Based Soft-Error Tolerance to Rescue Nanometer Technologies," VLSI Test Symposium (VTS), 1999. Par la suite, les éléments d'échantillonnage à l'entrée des éléments de délai seront appelés des éléments d'échantillonnage primaires tandis que les éléments d'échantillonnage à la sortie des éléments de délai seront appelés des éléments d'échantillonnage secondaires. Les éléments d'échantillonnage primaires sont des bascules utilisées pour effectuer les calculs correspondant à la fonctionnalité du circuit, tandis que les éléments d'échantillonnage secondaires sont des bascules utilisées pour la comparaison des signaux à l'entrée et à la sortie des éléments de délai. Une différence entre les deux valeurs échantillonnées indique une faute de délai qui ne s'est pas encore manifestée comme une erreur et dont la valeur est inférieure à la marge temporelle normalement introduite dans les périodes d'horloge pour absorber les variations de la latence des circuits numériques. Dès qu'une faute de délai est détectée, un signal d'erreur ou d'alerte est généré.

La publication de Yanagawa et al,intitulée « Experimental Vérification of Scan-Architecture-Bases Evaluation Technique of SET and SEU Soft Error Rates at Each Flip-Flop in Logic VLSI Systems", IEEE Transactions on Nuclear Science IEEE, Service Center, New York, vol.56, N°4, 1er août 2009, pages 1958-1963, ISSN:0018:9499 décrit un dispositif de test et de surveillance ou gestion de circuits numériques permettant la détection d'événements singuliers.

Un des objectifs de la présente invention est de fournir un dispositif de test et de monitoring associé à des bascules dans un circuit séquentiel afin de :
- réduire l'impact sur la performance des solutions en vue du test basées sur des chaînes de scan,
- permettre la détection en ligne des fautes de délai basée sur un double échantillonnage décalé dans le temps.

Le dispositif selon l'invention peut s'intégrer dans des chaînes de scan et permet d'éviter l'utilisation des bascules scan standard, connues de l'Homme du métier, sur des chemins critiques.

L'objet de la présente invention concerne un dispositif de test et de surveillance ou monitoring de circuits numériques pour détecter des fautes de délai affectant un signal D reçu directement en entrée d'une bascule appelée élément d'échantillonnage primaire, ledit élément d'échantillonnage primaire fournissant une première valeur D₁ du signal D et recevant un premier signal d'horloge pour sa mise à jour, ledit dispositif de test et de monitoring comportant au moins :
- un module logique scan introduisant une latence au niveau du signal D, ledit module logique scan ayant une première entrée recevant le signal « D », une deuxième entrée recevant un signal « scan in » et une troisième entrée recevant un signal « scan enable » adapté à sélectionner le mode de fonctionnement du dispositif de test et de monitoring dans un mode scan ou dans un mode fonctionnel, une sortie reliée à un élément d'échantillonnage secondaire du signal « D » et fournissant un deuxième signal échantillonné D₂ du signal « D » après passage dans le module logique scan, ledit élément d'échantillonnage secondaire recevant un deuxième signal d'horloge pour la mise à jour de son état,
- un module de comparaison du signal D₁ et du signal D₂ générant un signal d'alerte ou d'erreur.

Le module fournissant un signal de «reset» de l'élément d'échantillonnage primaire comprend, par exemple, deux portes NAND adaptées à générer un «reset» sélectif en mode scan et un «reset» normal en mode fonctionnel.

Selon une variante de réalisation, le module fournissant un signal de « reset» à l'élément d'échantillonnage primaire comprend une porte NAND ayant une première entrée recevant un signal reset et une deuxième entrée recevant le signal de sortie de l'élément d'échantillonnage secondaire « scan out » inversé et l'élément d'échantillonnage primaire est choisi afin que son état soit forcé à la valeur 1-logique dès que le signal « scan enable » prend la valeur 1-logique.

Le dispositif peut comporter un module fournissant un signal de «reset» (remise à zéro) dudit élément d'échantillonnage primaire.

Le dispositif comporte, par exemple, un module adapté à générer un signal pour contrôler le maintien de l'état dudit élément d'échantillonnage primaire.

Selon une variante de réalisation, le premier signal d'horloge et le deuxième signal d'horloge sont identiques.

Ledit élément d'échantillonnage secondaire et le module « logique scan » forment, par exemple, une bascule standard.

Le dispositif peut comporter une porte XOR utilisée pour comparer les versions du signal « D » échantillonnées par ledit élément d'échantillonnage primaire et par ledit élément d'échantillonnage secondaire.

Le dispositif comporte, par exemple, un inverseur sur le chemin du deuxième signal d'horloge.

Le dispositif comporte, par exemple, un élément de délai disposé sur le chemin du premier signal d'horloge et/ou disposé sur le chemin du deuxième signal d'horloge.

Le module « logique scan » comporte, par exemple, un multiplexeur contrôlé par le signal « scan enable ».

Selon une autre variante de réalisation, le module « logique scan » comporte, une porte XNOR, une porte NOR et une porte NAND ou une porte XOR, une porte NOR et une porte NAND.

Pour un élément d'échantillonnage primaire comprenant une entrée explicite pour un signal de maintien ou signal « hold », le module maintien logique ou « logique hold » est composé d'une porte NAND dont les entrées « scan enable » et « hold » sont inversées.

Dans le cas d'un élément d'échantillonnage primaire comprenant une entrée explicite pour un signal de maintien « hold », le module « logique hold » est composé de deux portes NAND dont l'entrée « hold » est inversée.

Pour un élément d'échantillonnage primaire ne comportant pas d'entrée explicite pour un signal de maintien « hold », le module « logique hold » est composé d'une porte NOR recevant le premier signal d'horloge et le signal « scan enable » en entrée.

Pour un élément d'échantillonnage primaire ne comportant pas d'entrée explicite pour un signal de maintien « hold », le module « logique hold » est composé d'une porte NOR et une porte AND, la porte NOR reçoit sur une première entrée le premier signal d'horloge et sur une deuxième entrée la sortie de la porte AND.

Pour un élément d'échantillonnage primaire ne comportant pas d'entrée explicite pour un signal de maintien « hold », le module « logique hold » contient une première porte NAND et une deuxième porte NAND, la première porte NAND reçoit sur une première entrée le premier signal d'horloge et sur une deuxième entrée la sortie de la deuxième porte NAND.

Pour un élément d'échantillonnage primaire ne comportant pas d'entrée explicite pour un signal de maintien « hold » et qui dispose d'une entrée de « reset » synchrone avec le premier signal d'horloge, l'entrée correspondant au signal « reset » dans le module « logique hold » est bloquée à la valeur 0-logique.

Au moins une partie des éléments d'échantillonnage primaire et/ou secondaire est adaptée à mettre à jour leur état sur le front descendant de leur signal d'horloge.

Selon une variante de réalisation, au moins une partie des éléments d'échantillonnage primaire et/ou secondaire est adaptée à mettre à jour leur état sur le niveau haut ou bas de leur signal d'horloge.

L'invention concerne aussi l'utilisation du dispositif présentant l'une des caractéristiques précitées dans un circuit qui comporte plusieurs chaînes de scan comprenant un ou plusieurs dispositifs de test et de surveillance ou « monitoring », lesdits dispositifs de test et de monitoring étant disposés sur des chemins critiques dudit système.

Ou encore, l'invention concerne l'utilisation du dispositif présentant au moins l'une des caractéristiques précitées dans un circuit comprenant plusieurs chaînes de scan contenant au moins un dispositif de test et de monitoring selon l'invention.

D'autres caractéristiques et avantages du dispositif selon l'invention apparaîtront mieux à la lecture de la description qui suit d'un exemple de réalisation donné à titre illustratif et nullement limitatif annexé des figures qui représentent :
- La figure 1A, la figure 1B et la figure 2, un exemple de dispositifs de test et monitoring selon l'invention,
- Les figures 3A et 3B, deux modalités d'implémentation pour les éléments « logique scan » des figures 1A et 2, respectivement,
- La figure 4, deux exemples de modalités d'implémentation pour l'élément « logique hold » de la figure 1A,
- La figure 5, trois exemples de modalités d'implémentation pour l'élément « logique hold » de la figure 2,
- La figure 6, un exemple d'architecture de chaîne de scan qui comporte des dispositifs selon les figures 1A et 2,
- La figure 7, un chronogramme avec trois signaux utiles pour le contrôle de la phase de test d'un circuit contenant des chaînes de scan selon la figure 6,
- La figure 8, une architecture de chaînes de scan pour des circuits pipelinés basés sur des dispositifs de la figure 2, et
- La figure 9, un procédé de test mis en oeuvre dans des architectures selon la figure 8.

Dans la suite de la description, à titre d'exemple illustratif, il est considéré que l'état des éléments d'échantillonnage est remis à jour sur le front montant du signal d'horloge qui arrive à ces éléments d'échantillonnage. Pour les éléments d'échantillonnages qui ont une entrée explicite permettant d'imposer le maintien de leur état, la valeur 1-logique prise par le signal qui contrôle leur maintien appelé ici « hold » indique le maintien de l'état de ces éléments d'échantillonnage. Pour les éléments d'échantillonnage qui ont des entrées explicites permettant leur remise à zéro, cette opération est contrôlée par un signal appelé « reset » et déclenchée quand ce signal prend la valeur 1-logique. Pour les éléments d'échantillonnage qui peuvent être contrôlés par les signaux de type « hold » et « reset », il est considéré que c'est le signal « reset » qui a la priorité. Le signal « scan enable » est utilisé pour définir deux modes de fonctionnement : un mode scan quand le signal « scan enable » prend la valeur 1-logique et un mode fonctionnel ou normal quand le signal « scan enable » prend la valeur 0-logique.

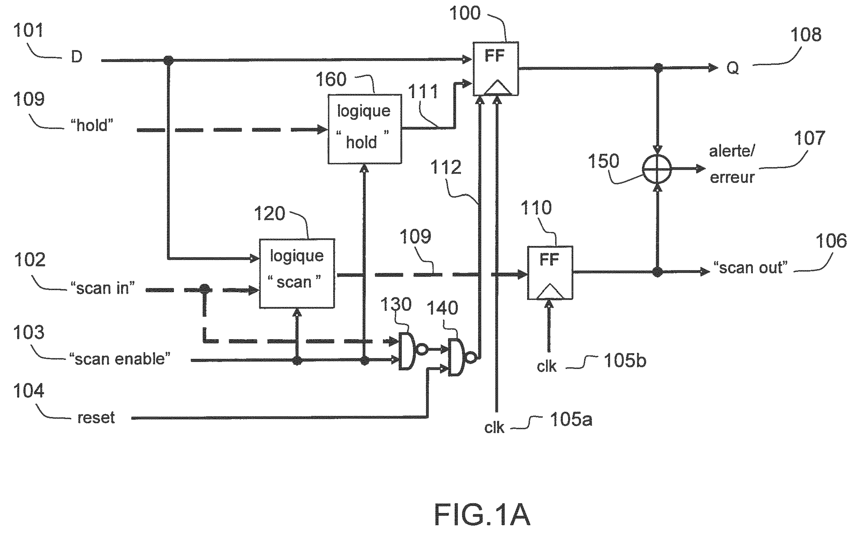

La figure 1A est un exemple de dispositif de test et de monitoring associé à une bascule 100. Ce dispositif selon l'invention peut être inséré dans des chaînes de scan et peut être utilisé pour la détection en ligne des fautes de délai affectant le signal « D » 101 basée sur un double échantillonnage décalé dans le temps. Le signal « D » 101 peut être doublement échantillonné par la bascule standard 100 qui est un élément d'échantillonnage primaire et par la bascule 110 qui est un échantillonnage secondaire après avoir parcouru un module « logique scan » 120.

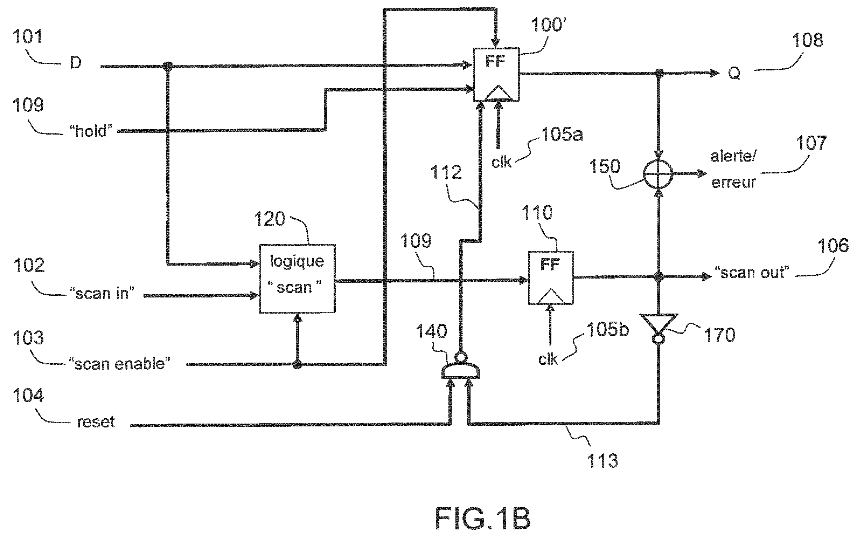

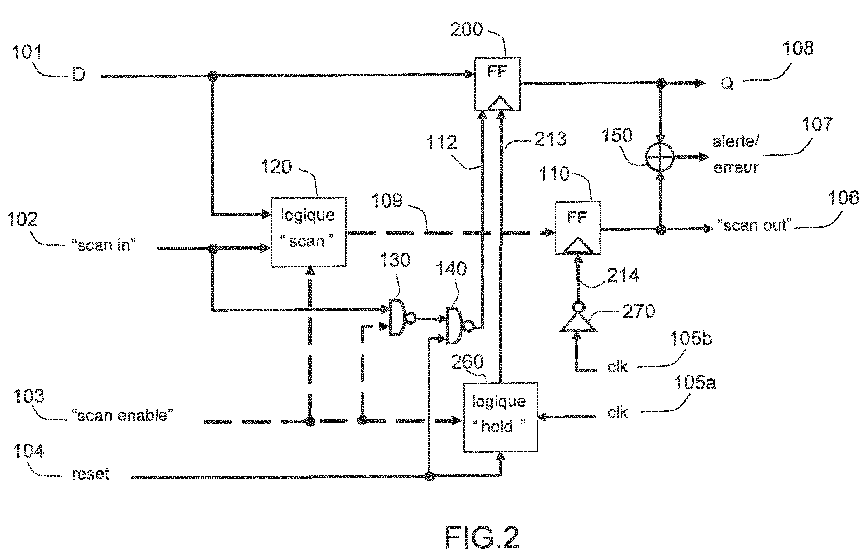

Le signal D est transmis directement au premier élément d'échantillonnage sans passer par un multiplexeur, ou un autre type de module scan logique, comme il est représenté en figures 1A, 1B et 2.

La bascule 100, associée au dispositif de test et de monitoring selon l'invention, comprend une entrée explicite 111 qui permet de gérer l'état de la bascule, et notamment d'imposer le maintien de son état. Pour cela, un module « logique hold » 160 génère le signal permettant le maintien de l'état de la bascule 100 en mode scan. La bascule 100 reçoit aussi un premier signal d'horloge 105a qui cadence la capture du signal « D » 101.

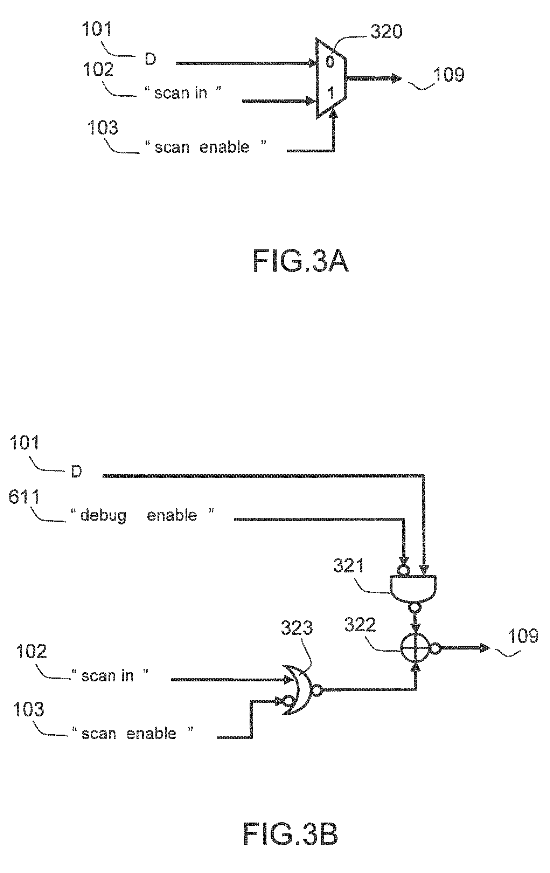

Le dispositif comporte aussi un module « logique scan » 120 dont une première entrée 120₁ reçoit le signal « D » et une deuxième entrée 120₂ reçoit le signal entrée scan ou « scan in ». Une troisième entrée 120₃ reçoit un signal « scan enable » 103. Ce module « logique scan » 120 avec le signal 103 permettent de choisir le signal appliqué à l'entrée de la bascule 100. Le signal « scan in » est choisi en mode scan et le signal « D » 101 est choisi en mode fonctionnel. Les signaux entrée scan ou « scan in » et sortie scan ou « scan out » représentent les connections aval et amont du dispositif selon l'invention proposé dans une chaîne de scan. Deux exemples d'implémentations possibles du module « logique scan » 120 sont données en figures 3A et 3B. Le module scan logique est adapté pour permettre l'insertion de l'élément d'échantillonnage secondaire dans une chaîne scan.

La sortie 120s du module « logique scan » 120 est reliée à la bascule 110. La bascule 110 est ainsi positionnée après le module « logique scan » 120, ou en aval c'est-à-dire que le signal D va d'abord parcourir le module « logique scan » avant qu'il soit échantillonné par la bascule 110. La bascule 110 reçoit le signal 109 de sortie du module logique scan 160 et génère un signal «scan out » 106 en sortie de bascule. Cette bascule 110 peut être implémentée de façon qu'elle soit moins rapide mais aussi plus petite que la bascule 100. La bascule 110 reçoit un deuxième signal horloge, 105b, par exemple le même que celui reçu par la bascule 100. Les deux valeurs D₁, D2 du signal « D », capturées par la bascule 100 et la bascule 110, sont comparées, dans cet exemple de mise en oeuvre, au moyen d'une porte XOR, 150, dont le résultat peut être vu comme un signal d'erreur ou une alerte 107. Sans sortir du cadre de l'invention, il est possible d'utiliser le dispositif sans la porte 150.

Selon une variante de réalisation, l'élément d'échantillonnage primaire 100 est adapté à mettre à jour son état sur le front descendant du signal d'horloge 105a. Selon une autre variante, l'élément d'échantillonnage primaire 100 est adapté à mettre à jour leur état sur le niveau haut ou bas du signal d'horloge 105a.

Selon une variante de réalisation, l'élément d'échantillonnage secondaire 110 est adapté à mettre à jour son état sur le front descendant du signal d'horloge 105b. Selon une autre variante, l'élément d'échantillonnage secondaire 110 est adapté à mettre à jour leur état sur le niveau haut ou bas du signal d'horloge 105b.

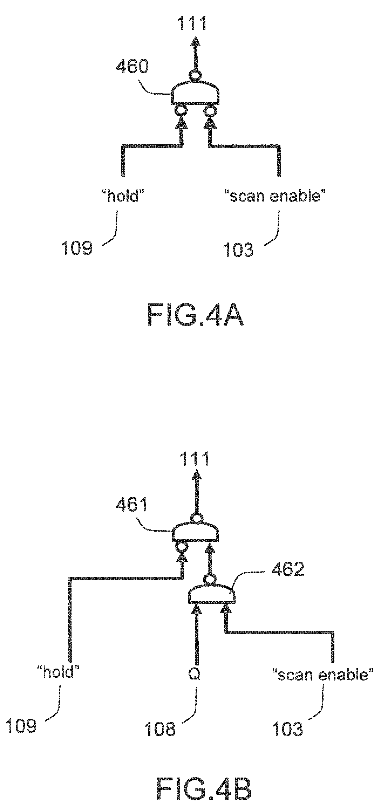

Le module « logique hold » 160 est adapté à générer le signal qui permet le maintien de l'état de la bascule 100 en mode scan. Ce maintien est, par exemple, imposé de manière sélective à l'aide d'un signal « hold » 109 combiné avec le signal « scan enable » 103, et potentiellement, avec le signal « Q » 108 correspondant à la sortie de la bascule 100. Des exemples d'implémentations possibles pour le module « 160 » sont donnés à la figure 4. La présence du module « logique hold » 160 est optionnelle. En l'absence de ce module, le signal « hold » 109 est connecté directement à l'entrée 111 de la bascule 100. Le signal « hold » peut lui-même être optionnel.

Deux portes NAND (et-logique inversé), 130 et 140, assurent la génération d'un signal de « reset » ou signal de remise à zéro, 112, pour la bascule 100. Il est considéré que la bascule 100 est remise à zéro quand le signal 112 prend la valeur 0-logique. En mode fonctionnel, le signal 112 est contrôlé seulement par le signal « reset » 104 car le signal « scan enable » 103 prend la valeur 0-logique. En mode scan, caractérisé par la valeur 1-logique du signal « scan enable » 103, la bascule 100 peut être remise à zéro de manière sélective à l'aide des signaux « scan in » 102 et « reset » 104. Le signal 112 peut être forcé de prendre la valeur 1-logique, ce qui empêche la bascule 100 d'être resetée, si le signal « scan in » 102 prend la valeur 1-logique. Le signal 112 prend la valeur 0-logique et la bascule 100 est resetée si le signal « scan in » 102 prend la valeur 0-logique et le signal « reset » 104 prend la valeur 1-logique. Les portes 130 et 140 sont optionnelles et en leur absence le signal « reset » 104 doit être inversé et connecté directement à l'entrée 112 de la bascule 100. Dans le cas où la bascule 100 ne dispose pas d'entrée « reset » 112, les portes 130 et 140 ainsi que le signal « reset » 104 ne sont pas nécessaires. D'autres combinaisons de portes logiques ou d'implémentations optimisées au niveau transistor peuvent être implémentées par l'homme du métier afin d'obtenir le même contrôle du signal 112.

La figure 1B schématise une variante pour laquelle le dispositif selon l'invention ne comporte pas de module « logique hold » 160. Le signal « hold » 109 est optionnel et dans le cas où il existe il est appliqué sur une entrée 111 d'un élément d'échantillonnage primaire 100'.

La porte NAND 140 reçoit le signal « reset » 104 sur une première entrée. Une deuxième entrée 113 est pilotée par le signal de sortie, « scan out » 106, de l'élément d'échantillonnage secondaire 110, le signal « scan out » étant inversé au travers un inverseur 170. L'élément d'échantillonnage primaire 100' est choisi de telle manière que son état soit forcé à la valeur 1-logique dès que le signal «scan enable » 103 prend la valeur 1-logique. Par exemple, l'élément d'échantillonnage primaire 100' peut être implémenté à l'aide d'une bascule avec une entrée de type « set » qui est pilotée par le signal « scan enable » 103. Les autres éléments restent identiques à ceux décrits à la figure 1A.

La figure 2 schématise une variante de réalisation du dispositif illustré en figure 1A pour des bascules 200 qui ne possèdent pas d'entrée explicite permettant d'imposer le maintien de leur état. Sur cette figure les éléments identiques à ceux décrits à la figure 1A portent les mêmes références.

Dans cette variante de réalisation, le maintien de l'état de ces bascules est obtenu à travers le masquage du signal d'horloge « clk » 105a, par exemple à l'aide d'un module « logique hold » 260.

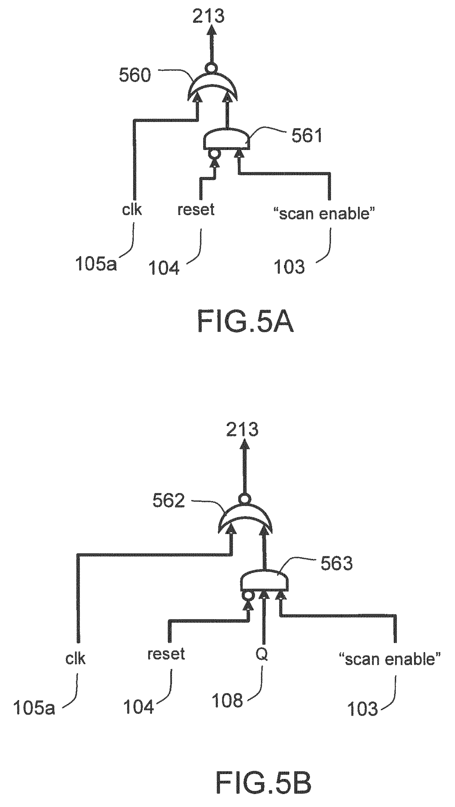

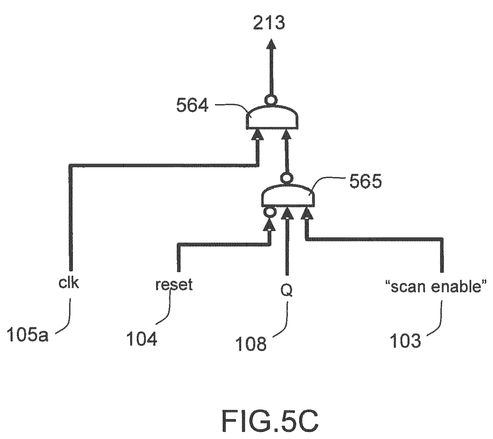

En mode scan, le maintien de l'état des bascules est sélectif car le module « logique hold » 260 est contrôlé, en dehors du signal d'horloge « clk » 105a, par le signal « scan enable » 103 et potentiellement par le signal « Q » 108, le signal correspond au signal « D » après passage dans la bascule 200. Le signal « reset » 104 en entrée du module « logique hold » 260 est nécessaire seulement si la bascule 200 dispose d'une entrée de reset synchrone. Des implémentations possibles pour le module 260 sont décrites en figure 5.

Un inverseur 270 est disposé sur le chemin du signal d'horloge «clk» 105b et avant la bascule 110. Dans le cas où les deux signaux d'horloge 105a et 105b sont identiques, cet inverseur permet avantageusement de garantir que l'élément d'échantillonnage primaire, ou bascule 200, et l'élément d'échantillonnage secondaire 110 mettent à jour leur état sur un même événement (front ou niveau) du signal d'horloge et d'équilibrer le chemin parcouru par le signal d'horloge «clk» 105a jusqu'à l'élément d'échantillonnage primaire 200 et le chemin parcouru par le signal d'horloge « clk » 105b jusqu'à l'élément d'échantillonnage secondaire 110. Il est possible aussi de ne pas utiliser d'inverseur 270, dans ce cas, le signal d'horloge 105b est relié directement à la bascule 110.

Dans les deux dispositifs décrits dans les figures, le module « logique scan » 120 introduit une différence de latence entre les chemins parcourus par les deux versions D₁, D₂ du signal « D » avant d'arriver aux éléments d'échantillonnage primaire et secondaire. Cette différence de latence est utilisée comme fenêtre de détection pour les fautes de délai. Afin d'ajuster la fenêtre de détection introduit par cette latence, il est possible d'insérer un élément de délai, tel qu'un tampon ou « buffer », sur les chemins des signaux d'horloge « clk »,105a et 105b, arrivant respectivement aux éléments d'échantillonnage primaire 100, 100' et 200, ou secondaire 110.

Sans sortir du cadre de la présente invention, les deux exemples de dispositifs décrits dans les figures 1A et 2, peuvent être mis en oeuvre à l'aide d'autres combinaisons de portes logiques ou d'implémentations optimisées au niveau transistor.

Les dispositifs décrits aux figures 1A, 1B et 2, permettent aussi la détection en ligne de fautes transitoires. Dans le cas où ce type de fautes doit être pris en compte, le signal 107 en sortie de la porte 150, est considéré comme un signal d'erreur. Dans le cas contraire, le signal 107 peut être considéré comme un signal d'alerte indiquant seulement un risque d'erreur.

Afin de réduire la puissance consommée par les dispositifs décrits en figures 1A, 1B et 2, l'élément d'échantillonnage secondaire 110, l'élément «logique scan » 120 et l'élément 150 peuvent être déconnectés de l'alimentation pendant des modes de fonctionnement où il n'y a pas besoin d'effectuer d'opérations de test ou de monitoring.

La figure 3A présente un premier mode d'implémentation pour le module « logique scan » 120. Cette implémentation est composée d'un multiplexeur 320 contrôlé par le signal «scan enable » 103, le multiplexeur recevant le signal « D » 101 et le signal « scan in » 102.

La figure 3B représente un deuxième schéma d'implémentation, qui comprend une porte XNOR (ou-logique exclusive inversé) 322, une porte NOR (ou-logique inversé) 323 et une porte NAND (et-logique inversé) 321. Les signaux «scan enable » 103 et activation du mode débogage ou « debug enable » 311 arrivants sur ces portes doivent être inversés. La porte 322 peut être remplacée par une porte XOR (ou-logique exclusive) non représentée pour des raisons de simplification, à condition de modifier l'utilisation du signal 109 de façon appropriée. Le signal « debug enable » 311 peut être remplacé par le signal « scan enable » 103. De plus, la porte 321 est optionnelle et, en son absence, le signal « D » 101 peut être relié directement à l'entrée de la porte XNOR 322. D'autres combinaisons de portes logiques ou d'implémentations optimisées au niveau transistor peuvent être utilisées par l'Homme du métier, sans sortir du cadre de l'invention, sous réserve qu'elles présentent la même fonctionnalité que celle des dispositifs des figures 3A et 3B.

L'ensemble formé par l'élément d'échantillonnage secondaire 110 en figures 1A, 1B et 2 et l'élément « logique scan » 120 tel qu'il est implémenté en figure 3A constitue l'équivalent d'un type de bascule scan standard, bascule à multiplexage des entrées, appelée en Anglais « multiplexed data flip-flop », d'après la terminologie utilisée dans la publication de M. Abramovici, M.A. Breuer, A.D. Friedman « Digital Systems Testing and Testable Design », IEEE Press, 1990, pages 369-370. Cet ensemble peut être remplacé par un autre type de bascule scan standard comme, par exemple, architecture scan à l'aide de la logique sensible à niveau « level-sensitive scan design » (LSSD), bascule double port ou « two-port dual-clock flip-flop », bascule pour registre à décalage avec multiplexage des entrées ou « multiplex data shift register latch » décrits dans la même publication, pages 370-372. Des modifications facilement identifiables par l'Homme du métier permettent d'utiliser d'autres types de bascule scan standard, comme, par exemple, ceux mentionnés ci-dessus, à la place de la bascule scan standard « multiplexed data flip-flop ».

Les figures 4A et 4B représentent deux exemples d'implémentations possibles du module « logique hold » 160 pour des éléments d'échantillonnage primaires 100 qui ont une entrée explicite permettant d'imposer le maintien de leur état.

La première implémentation figure 4A est composée d'une porte NAND (et-logique inversé) 460 dont les entrées « scan enable » 103 et « hold » 109 définies en figure 1 doivent être inversées. Dans cette implémentation, l'état de la bascule 100 est maintenu si un des deux signaux « hold » 109 ou « scan enable » 103 prend la valeur 1-logique.

La deuxième implémentation figure 4B permet un maintien sélectif en mode scan à l'aide supplémentaire du signal « Q » 108 en entrée. Cette implémentation nécessite deux portes NAND (et-logique inversé) 461 et 462 dont l'entrée qui correspond au signal « hold » 109 doit être inversée. Dans cette implémentation, l'état de la bascule 100 est maintenu : si (i) le signal « hold » 109 prend la valeur 1-logique ou (ii) si les signaux « Q » 108 et « scan enable » 103 prennent la valeur 1-logique.

D'autres combinaisons de portes logiques ou d'implémentations optimisées au niveau transistor peuvent être implémentées par l'homme du métier afin d'obtenir la même fonctionnalité que celle fournie par les dispositifs des figures 4A et 4B.

Les figures 5A, 5B et 5C présentent trois implémentations possibles du module « logique hold » 260 pour des éléments d'échantillonnage primaires 200 (figure 2) qui n'ont pas d'entrée explicite permettant d'imposer le maintien de leur état. Dans les deux premières implémentations figures 5A et 5B, l'état de la bascule 200 est maintenu en bloquant le signal d'horloge 213 à la valeur 0-logique tandis que, dans la troisième implémentation figure 5C, le signal d'horloge 213 est bloqué à la valeur 1-logique. Les implémentations des figures 5B et 5C permettent un maintien sélectif en mode scan à l'aide supplémentaire du signal « Q » 108 en entrée.

La première implémentation, en figure 5A, est composée d'une porte NOR (ou-logique inversé) 560 et d'une porte AND (et-logique) 561. La porte 560 reçoit le signal d'horloge 105a en entrée et un signal correspondant à la sortie de la porte 561. Dans cette implémentation, l'état de la bascule 200 est maintenu si le signal « scan enable » 103 prend la valeur 1-logique et le signal « reset » 104 prend la valeur 0-logique.

La deuxième implémentation, en figure 5B, est composée d'une porte NOR (ou-logique inversé) 562 et une porte AND (et-logique) 563. La porte 562 reçoit sur une première entrée le signal d'horloge 105a et sur une deuxième entrée la sortie de la porte 563. Dans cette implémentation, l'état de la bascule 200 est maintenu si les signaux « scan enable » 103 et « Q » 108 prennent la valeur 1-logique et le signal « reset » prend la valeur 0-logic.

Dans sa troisième implémentation, en figure 5C, le module « logique hold » contient deux portes NAND (et-logique inversé) 564 et 565, la sortie de la porte 565 correspond à une entrée de la porte 564. Le maintien de l'état de la bascule 200 est assuré par les mêmes conditions nécessaires au maintien dans le cas de l'implémentation figure 5B. La seule différence est que dans le cas de l'implémentation figure 5B il faut considérer comme contrainte supplémentaire que la sortie de la porte 565 ne doit pas subir une transition de 1-logique à 0-logique pendant que le signal d'horloge « clk » 105a est à la valeur 1-logique.

Dans les dispositifs figue 5A, figure 5B et figure 5C, l'utilisation du signal « reset » est nécessaire seulement si la bascule 200 dispose d'une entrée de « reset » synchrone avec le signal d'horloge « clk » 105a. Dans ce cas, les portes 563 et 565 ont seulement deux entrées correspondant aux signaux « Q » 108 et « scan enable » 103 tandis que la porte 561 n'est plus nécessaire, le signal « scan enable » 103 étant directement connecté à la porte 560. L'élimination du signal « reset » 104 est équivalente au blocage à la valeur 0-logique de l'entrée qui reçoit ce signal dans les portes 561, 563 et 565. D'autres combinaisons de portes logiques ou d'implémentations optimisées au niveau transistor peuvent être utilisées par l'homme du métier afin d'obtenir la même fonctionnalité que celle fournie par les dispositifs des figures 5A, 5B et 5C.

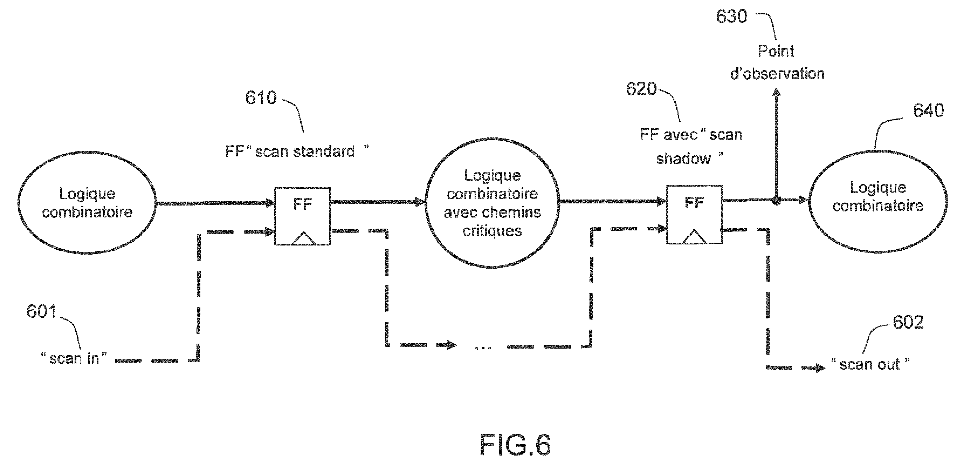

La figure 6 présente un exemple d'architecture d'une chaîne de scan appelée scan mixte ou « mixed-scan » pouvant contenir des bascules scan standard 610 et des dispositifs de test et monitoring, similaires aux dispositifs présentés dans les figures 1A, 1B et 2, associés à des bascules 620. A la différence des dispositifs de test et monitoring proposés, les bascules scan standard 610 sont employées, à la fois, pour effectuer les calculs correspondant à la fonctionnalité d'un circuit et pour faciliter le test de ce circuit. Les bascules 620, sans les dispositifs de test et monitoring, peuvent être utilisées seulement pour effectuer les calculs correspondant à la fonctionnalité d'un circuit.

Dans le circuit où une telle chaîne de scan est insérée, il est considéré qu'au moins une partie des bascules qui se trouvent sur des chemins critiques sont protégées par des dispositifs similaires à ceux présentés, par exemple, dans les figures 1A, 1B et 2. Dans ce cas, ces dispositifs sont inclus dans une ou plusieurs chaînes de scan tandis que les éléments d'échantillonnage primaires ne sont pas inclus dans des chaînes de scan afin de ne pas affecter la latence du circuit. Les sorties des bascules 620 qui ne sont pas dans des chaînes de scan peuvent être observées à l'aide de points d'observation 630 connus par l'homme du métier dans le domaine de la conception en vue d'une meilleure testabilité. Ces points d'observation peuvent être à leur tour insérés dans des chaînes de scan ou dans des registres à décalage à rétroaction linéaire à chargement parallèle ou MISRs (Multiple-Input Signature Registers) connus de l'Homme du métier.

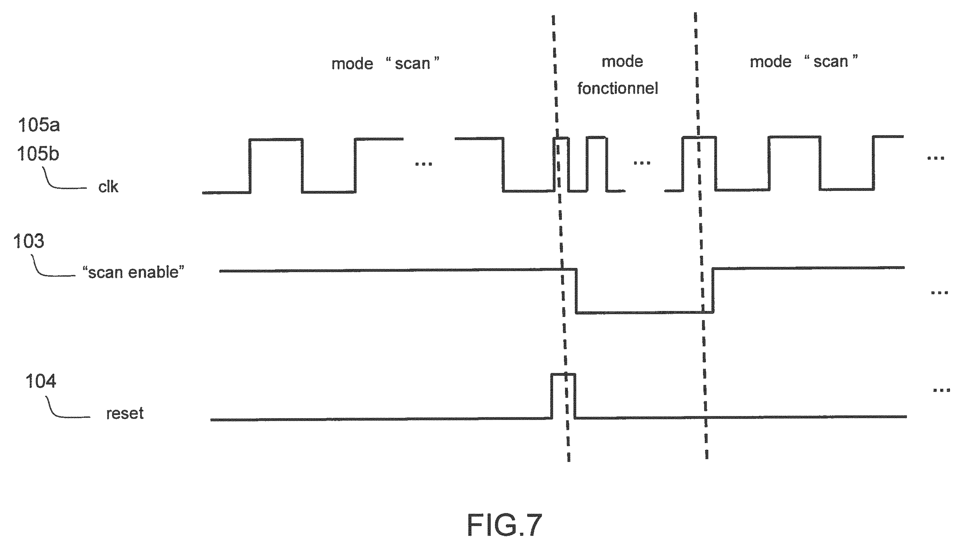

La figure 7 schématise un exemple pour la forme des signaux utilisés au cours d'un procédé de test de production comprenant une succession de modes scan et fonctionnel. Dans cet exemple trois signaux permettent le contrôle du test d'un circuit comprenant une configuration de chaînes de scan similaire à celle illustrée en figure 6.

Le signal « reset » 104 prend la valeur 1-logique pendant le dernier cycle d'horloge exécuté en mode scan, défini par la valeur 1-logique du signal «scan enable » 103, afin de reseter sélectivement les éléments d'échantillonnage primaires qui ne sont pas inclues dans des chaînes de scan et qui disposent d'un dispositif de test et monitoring tel que introduit dans ce brevet. En mode scan, ce signal de « reset » 104 ne doit pas affecter les bascules scan standard. En mode fonctionnel, il suffit d'appliquer un ou plusieurs cycles à la fréquence la plus proche possible de la fréquence cible du circuit.

Cet exemple correspond à la situation où les deux signaux d'horloge 105a et 105b sont identiques et l'ensemble formé par les éléments 110 et 120 (tel qu'implémenté en figure 3A, par exemple) est équivalent au type de bascule scan standard appelée en Anglais « multiplexed data flip-flop » et mentionnée auparavant.

Selon un autre mode de réalisation, le signal « reset » 104 prend la valeur 1-logique pendant le premier cycle d'horloge exécuté en mode fonctionnel défini par la valeur 0-logique du signal « scan enable » 103, et il revient à la valeur 0-logique avant le premier front montant du signal d'horloge toujours en mode fonctionnel. Ceci permet de reseter sélectivement les éléments d'échantillonnage primaires qui ne sont pas inclus dans des chaînes de scan et qui disposent d'un dispositif de test et monitoring selon l'invention.

Sans sortir du cadre de l'invention, pour les dispositifs décrits en figures 1A-5 et 7, un Homme du métier peut aisément mettre en oeuvre les modifications nécessaires à ces derniers dans le cas où au moins une des situations suivantes se présente :
(i) une partie ou tous les éléments d'échantillonnage 100, 100', 110 et 200 peuvent mettre à jour leur état lors du front descendent du signal d'horloge arrivant à ces éléments d'échantillonnage,
(ii) une partie ou tous les éléments d'échantillonnage 100, 100', 110 et 200 peuvent mettre à jour leur état sur le niveau haut ou le niveau bas du signal d'horloge arrivant à ces éléments d'échantillonnage,
(iii) les valeurs 1-logique du signal 112 et 0-logique du signal « reset » 104 sont utilisées pour reseter les éléments d'échantillonnage primaires 100 et 200,
(iv) la valeur 0-logique du signal « hold » 109 et 111 est utilisée pour assurer le maintien de l'état de l'élément d'échantillonnage primaire 100,
(v) les valeurs du signal « scan enable » 103 utilisées pour signaler les modes scan et fonctionnel sont inversées.
(vi) l'ensemble formé par les éléments 110 et 120 (figures 1A, 1B et 2) est équivalent à un autre type de bascule scan standard comme, par exemple, « level-sensitive scan design » (LSSD), « two-port dual-clock flip-flop », « multiplex data shift register latch » mentionnées auparavant.

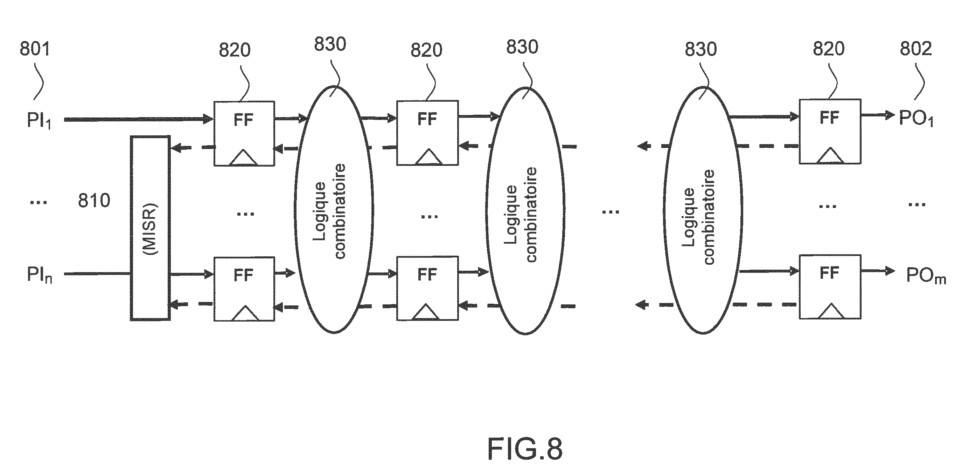

La figure 8 représente un autre exemple d'architecture de chaînes de scan qui peut être utilisé pour des circuits configurés en pipeline ou « pipelinés ».

Les éléments 820 représentent des bascules protégées par des dispositifs similaires à ceux présentés dans la figure 2 avec un module « logique scan » tel que implémenté en figure 3B. Les bascules protégées ne sont pas inclues dans des chaînes de scan et seulement ces dispositifs sont inclus dans des chaînes de scan. Il est recommandé que chaque chaîne de scan contienne un seul dispositif par étage de pipeline. L'information dans les chaînes de scan circule dans le sens opposé du flot d'information fonctionnelle. Par conséquent, les derniers dispositifs dans les chaînes de scan font partie des premiers étages du pipeline. Un registre multi-signature MISR (Multi-Input Signature Register) peut être utilisé pour compresser les sorties des chaînes de scan afin de permettre l'utilisation de chaînes de scan par un programme de test en ligne. L'état du MISR doit être accessible au programme de test en ligne, c'est-à-dire qu'il doit être possible de lire et au moins de reseter son état. De plus, le MISR doit être contournable pendant le test de production (hors ligne) afin de permettre une meilleure observabilité. Les entrées 801 et les sorties 802 sont des entrées et des sorties fonctionnelles du pipeline. Dans cette architecture, les chaînes de scan n'ont pas d'entrées provenant de l'extérieur.

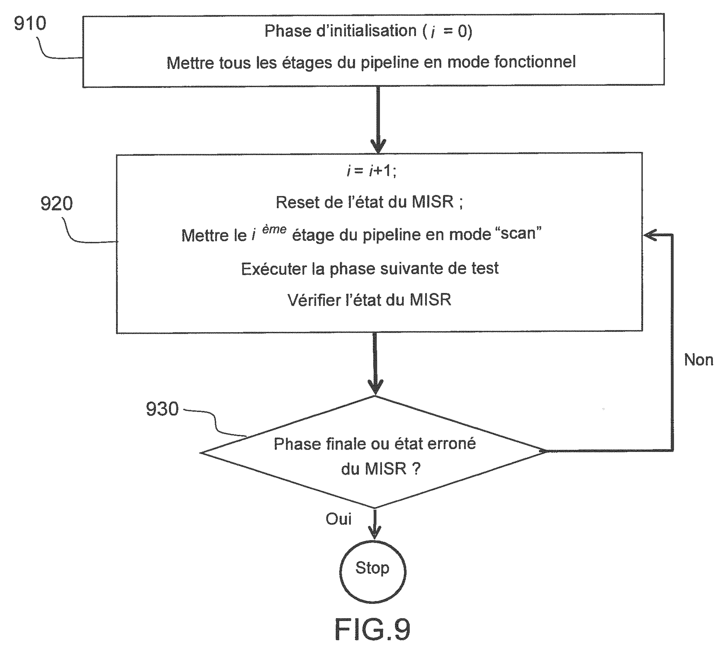

La figure 9 présente un diagramme des étapes mises en oeuvre dans un procédé de partition en plusieurs étapes d'un programme de test afin de réduire la probabilité de masquage d'erreur ou « aliasing » dans des circuits pipelinés contenant des dispositifs similaires à ceux représentés en figure 8.

En accord avec ce procédé, le programme de test commence avec une étape d'initialisation 910 avec tous les étages du pipeline en mode fonctionnel. L'étape d'initialisation est suivie par une succession d'étapes 920 au début desquelles un étage du pipeline est mis en mode observation et contrôle ou « mode scan ». Le premier étage à être mis en mode scan est l'étage à l'entrée du pipeline (tout à gauche en figure 8), c'est-à-dire l'étage qui contient les derniers éléments dans les chaînes de scan illustrées en figure 8. A chaque nouvelle étape 920, l'étage suivant qui jouxte le dernier étage passé en mode scan est à son tour passé en mode scan sans changer le mode des autres étages. Cela présuppose l'existence d'un signal « scan enable » pour chaque étage du pipeline qui est contrôlable par le programme de test. Par exemple, ces signaux « scan enable » peuvent être générés à partir de l'état d'un registre de contrôle. Le contenu du MISR illustré en figure 8 peut être reseté au début de chaque étape 920. L'arrêt du procédé est contrôlé à l'aide de l'étape 930 exécutée après chaque étape 920. Le procédé est arrêté si tous les étages ont été testés en mode scan ou si, à la fin d'une étape 920, l'état du MISR en figure 8 est incorrecte. A la fin, le programme de test doit indiquer le succès ou l'insuccès de l'opération de test. Pour ce type de test, le schéma présenté en figure 7 ne s'applique pas.

Le dispositif selon l'invention présente notamment comme avantage d'éviter l'insertion de bascules standard sur les chemins critiques et de fait de minimiser l'impact de solutions de conception en vue de test.

## Revendications

1. Dispositif de test et de surveillance ou monitoring de circuits numériques permettant la détection de fautes de délai affectant un signal D reçu directement en entrée d'une bascule appelée élément d'échantillonnage primaire (100, 200), ledit élément d'échantillonnage primaire fournissant une première valeur D₁ du signal D et recevant un premier signal d'horloge (105a) pour sa mise à jour, ledit dispositif de test et de monitoring **caractérisé en ce qu'**il comporte au moins :
• un module logique scan (120) introduisant une latence au niveau du signal D, ledit module logique scan (120) ayant une première entrée recevant le signal « D », une deuxième entrée recevant un signal « scan in » et une troisième entrée recevant un signal (103) « scan enable » adapté à sélectionner le mode de fonctionnement du dispositif de test et de monitoring dans un mode scan ou dans un mode fonctionnel, une sortie (120s) reliée à un élément d'échantillonnage secondaire (110) du signal D et fournissant un deuxième signal échantillonné D₂ du signal D après passage dans le module logique scan, ledit élément d'échantillonnage secondaire (110) recevant un deuxième signal d'horloge (105b) pour la mise à jour de son état,
• un module de comparaison (150) du signal D₁ et du signal D₂ générant un signal d'alerte ou d'erreur.

2. Dispositif selon la revendication 1 **caractérisé en ce qu'**il comporte un module fournissant un signal (112) de «reset» audit élément d'échantillonnage primaire (100).

3. Dispositif selon la revendication 2 **caractérisé en ce que** le module fournissant un signal de « reset » à l'élément d'échantillonnage primaire comprend deux portes NAND (130) et (140) adaptées à permettre un « reset » sélectif en mode scan et un « reset » normal en mode fonctionnel.

4. Dispositif selon la revendication 2 **caractérisé en ce que** le module fournissant un signal de « reset » à l'élément d'échantillonnage primaire comprend une porte NAND (140) ayant une première entrée recevant un signal reset (104) et une deuxième entrée (113) recevant le signal de sortie de l'élément d'échantillonnage secondaire « scan out » (106) inversé et **en ce que** l'élément d'échantillonnage primaire (100') est choisi afin que son état soit forcé à la valeur 1-logique dès que le signal « scan enable » (103) prend la valeur 1-logique.

5. Dispositif selon l'une des revendications 1 à 3 **caractérisé en ce qu'**il comporte un module (160, 260) adapté à générer un signal pour contrôler le maintien de l'état dudit élément d'échantillonnage primaire (100, 200).

6. Dispositif selon l'une des revendications 1 à 5 **caractérisé en ce que** le premier signal d'horloge (105a) et le deuxième signal d'horloge (105b) sont identiques.

7. Dispositif selon l'une des revendications 1 à 6 **caractérisé en ce que** l'ensemble formé par ledit élément d'échantillonnage secondaire (110) et le module « logique scan » (120) forment une bascule scan.

8. Dispositif selon l'une des revendications 1 à 7 **caractérisé en ce qu'**il comporte une porte XOR (150) utilisée pour comparer les versions du signal « D » échantillonnées par ledit élément d'échantillonnage primaire (100, 200) et par ledit élément d'échantillonnage secondaire (110).

9. Dispositif selon l'une des revendications 1 à 8 **caractérisé en ce qu'**il comporte un inverseur (270) sur le chemin du deuxième signal d'horloge (105b).

10. Dispositif selon l'une des revendications 1 à 9 **caractérisé en ce qu'**il comporte un élément de délai disposé sur le chemin du premier signal d'horloge (105a) arrivant à l'élément primaire d'échantillonnage et/ou un élément de délai disposé sur le chemin du deuxième signal d'horloge (105b) arrivant à l'élément secondaire d'échantillonnage (110).

11. Dispositif selon l'une des revendications 1 à 10 **caractérisé en ce que** le module « logique scan » (120) comporte un multiplexeur (320) contrôlé par le signal « scan enable » (103).

12. Dispositif selon l'une des revendications 1 à 11 **caractérisé en ce que** le module « logique scan » (120) comporte, une porte XNOR (322), une porte NOR (323) et une porte NAND (321) ou une porte XOR, une porte NOR (323) et une porte NAND (321).

13. Dispositif selon l'une des revendications 1 à 3 et 5 à 12 **caractérisé en ce que** pour un élément d'échantillonnage primaire (100) comprenant une entrée explicite pour un signal de maintien « hold », le module « logique hold » (160) est composée d'une porte NAND (460) dont les entrées « scan enable » (103) et « hold » (109) sont inversées.

14. Dispositif selon l'une des revendications 1 à 3 et 5 à 12 **caractérisé en ce que** pour un élément d'échantillonnage primaire (100) comprenant une entrée explicite pour un signal de maintien « hold », le module « logique hold » (160) est composé de deux portes NAND (461, 462) dont l'entrée « hold » (109) est inversée.

15. Dispositif selon l'une des revendications 1 à 3 et 5 à 12 **caractérisé en ce que** pour un élément d'échantillonnage primaire (200) ne comportant pas d'entrée explicite pour un signal de maintien « hold », le module « logique hold » (260) est composé d'une porte NOR (560) recevant le signal d'horloge (105a) et le signal « scan enable » (103) en entrée.

16. Dispositif selon l'une des revendications 1 à 3 et 5 à12 **caractérisé en ce que** pour un élément d'échantillonnage primaire (200) ne comportant pas d'entrée explicite pour un signal de maintien « hold », le module « logique hold » (260) est composé d'une porte NOR (560, 562) et une porte AND (561, 563), la porte NOR (560, 562) reçoit sur une première entrée le signal d'horloge (105a) et sur une deuxième entrée la sortie de la porte AND (563).

17. Dispositif selon l'une des revendications 1 à 3 et 5 à 12 **caractérisé en ce que** pour un élément d'échantillonnage primaire (200) ne comportant pas d'entrée explicite pour un signal de maintien « hold », le module « logique hold » (260) contient une première porte NAND (564) et une deuxième porte NAND (565), la première porte NAND (564) reçoit sur une première entrée le premier signal d'horloge (105a) et sur une deuxième entrée la sortie de la deuxième porte NAND (565).

18. Dispositif selon l'une des revendications 15, 16 et 17 **caractérisé en ce qu'**il comporte une porte AND (561, 563) ou une porte NAND (565), une des entrées desdites portes correspondant au signal « reset » (104) est bloquée à la valeur 0-logique.

19. Dispositif selon l'une des revendications 1 à 12 **caractérisé en ce que** au moins une partie des éléments d'échantillonnage primaire (100, 200) et/ou secondaire (110) sont adaptés à mettre à jour leur état sur le front descendant du signal d'horloge (105a, 105b).

20. Dispositif selon l'une des revendications 1 à 3 et 5 à12 **caractérisé en ce que** au moins une partie des éléments d'échantillonnage primaire (100, 200) et/ou secondaire (110) sont adaptés à mettre à jour leur état sur le niveau haut ou bas du signal d'horloge (105a, 105b).

## Patentansprüche

1. Vorrichtung zum Testen und Überwachen oder Monitoring von digitalen Schaltungen, die das Erkennen von Verzögerungsfehlern zulässt, die ein Signal D beeinflussen, das direkt am Eingang eines Latch empfangen wird, primäres Abtastelement (100, 200) genannt, wobei das primäre Abtastelement einen ersten Wert D₁ des Signals D bereitstellt und ein erstes Taktsignal (105a) für seine Aktualisierung empfängt, wobei die Test- und Überwachungsvorrichtung **dadurch gekennzeichnet ist, dass** sie wenigstens Folgendes umfasst:
• ein Scan-Logik-Modul (120), das eine Latenz in das Signal D einführt, wobei das Scan-Logik-Modul (120) Folgendes umfasst: einen ersten Eingang, der das Signal "D" empfängt, einen zweiten Eingang, der ein "scan in" Signal empfängt, und einen dritten Eingang, der ein "scan enable" Signal (103) empfängt, adaptiert zum Wählen des Funktionsmodus der Test- und Überwachungsvorrichtung in einem Scan-Modus oder in einem Funktionsmodus, einen Ausgang (120s), der mit einem sekundären Abtastelement (110) des Signals D verbunden ist und ein zweites Abtastsignal D₂ des Signals D nach der Passage in dem Scan-Logikmodul bereitstellt, wobei das sekundäre Abtastelement (110) ein zweites Taktsignal (105b) für die Aktualisierung seines Zustands empfängt,
• ein Vergleichsmodul (150) des Signals D₁ und des Signals D₂ das ein Alarm- oder Fehlersignal erzeugt.

2. Vorrichtung nach Anspruch 1, **dadurch gekennzeichnet, dass** sie ein Modul umfasst, das ein "Reset"-Signal (112) dem primären Abtastelement (100) bereitstellt.

3. Vorrichtung nach Anspruch 2, **dadurch gekennzeichnet, dass** das Modul, das ein "Reset"-Signal dem primären Abtastelement bereitstellt, zwei NAND-Ports (130) und (140) umfasst, ausgelegt zum Zulassen eines selektiven "Reset" im Scan-Modus und eines normalen "Reset" im Funktionsmodus.

4. Vorrichtung nach Anspruch 2, **dadurch gekennzeichnet, dass** das Modul, das ein "Reset"-Signal dem primären Abtastelement bereitstellt, einen NAND-Port (140) umfasst, der Folgendes umfasst: einen ersten Eingang, der ein Reset-Signal (104) empfängt, und einen zweiten Eingang (113), der das Ausgangssignal des sekundären "scan out" Abtastelements (106) umgekehrt empfängt, und dadurch, dass das primäre Abtastelement (100') gewählt wird, damit sein Zustand auf den logischen Wert 1 gebracht wird, sobald das "scan enable" Signal (103) den logischen Wert 1 einnimmt.

5. Vorrichtung nach einem der Ansprüche 1 bis 3, **dadurch gekennzeichnet, dass** sie ein Modul (160, 260) umfasst, das zum Erzeugen eines Signals zum Steuern des Haltens des Zustands des primären Abtastelements (100, 200) ausgelegt ist.

6. Vorrichtung nach einem der Ansprüche 1 bis 5, **dadurch gekennzeichnet, dass** das erste Taktsignal (105a) und das zweite Taktsignal (105b) identisch sind.

7. Vorrichtung nach einem der Ansprüche 1 bis 6, **dadurch gekennzeichnet, dass** die von dem sekundären Abtastelement (110) und dem "scan logic" Modul (120) gebildete Baugruppe einen Scan-Latch bilden.

8. Vorrichtung nach einem der Ansprüche 1 bis 7, **dadurch gekennzeichnet, dass** sie einen XOR-Port (150) umfasst, der zum Vergleichen der von dem primären Abtastelement (100, 200) und dem sekundären Abtastelement (110) abgetasteten Versionen des Signals "D" benutzt wird.

9. Vorrichtung nach einem der Ansprüche 1 bis 8, **dadurch gekennzeichnet, dass** sie einen Inverter (270) auf dem Pfad des zweiten Taktsignals (105b) umfasst.

10. Vorrichtung nach einem der Ansprüche 1 bis 9, **dadurch gekennzeichnet, dass** sie ein Verzögerungselement umfasst, das auf dem Pfad des ersten Taktsignals (105a) angeordnet ist, das an dem primären Abtastelement ankommt, und/oder ein Verzögerungselement, das auf dem Pfad des zweiten Taktsignals (105b) angeordnet ist, das an dem sekundären Abtastelement (110) ankommt.

11. Vorrichtung nach einem der Ansprüche 1 bis 10, **dadurch gekennzeichnet, dass** das "scan logic" Modul (120) einen Multiplexer (320) umfasst, der von dem "scan enable" Signal (103) gesteuert wird.

12. Vorrichtung nach einem der Ansprüche 1 bis 11, **dadurch gekennzeichnet, dass** das "scan logic" Modul (120) einen XNOR-Port (322), einen NOR-Port (323) und einen NAND-Port (321) oder einen XOR-Port, einen NOR-Port (323) und einen NAND-Port (321) umfasst.

13. Vorrichtung nach einem der Ansprüche 1 bis 3 und 5 bis 12, **dadurch gekennzeichnet, dass** für ein primäres Abtastelement (100), das einen expliziten Eingang für ein Haltesignal "hold" umfasst, das "hold logic" Modul (160) aus einem NAND-Port (460) zusammengesetzt ist, dessen Eingänge "scan enable" (103) und "hold" (109) umgekehrt sind.

14. Vorrichtung nach einem der Ansprüche 1 bis 3 und 5 bis 12, **dadurch gekennzeichnet, dass** für ein primäres Abtastelement (100), das einen expliziten Eingang für ein Haltesignal "hold" umfasst, das "hold logic" Modul (160) aus zwei NAND-Ports (461, 462) zusammengesetzt ist, deren Eingang "hold" (109) umgekehrt ist.

15. Vorrichtung nach einem der Ansprüche 1 bis 3 und 5 bis 12, **dadurch gekennzeichnet, dass** für ein primäres Abtastelement (200), das keinen expliziten Eingang für ein Haltesignal "hold" umfasst, das "hold logic" Modul (260) aus einem NOR-Port (560) zusammengesetzt ist, der das Taktsignal (105a) und das "scan enable" Signal (103) am Eingang empfängt.

16. Vorrichtung nach einem der Ansprüche 1 bis 3 und 5 bis 12, **dadurch gekennzeichnet, dass** für ein primäres Abtastelement (200), das keinen expliziten Eingang für ein Haltesignal "hold" umfasst, das "hold logic" Modul (260) aus einem NOR-Port (560, 562) und einem AND-Port (561, 563) zusammengesetzt ist, der NOR-Port (560, 562) an einem ersten Eingang das Taktsignal (105a) und an einem zweiten Eingang den Ausgang des AND-Ports (563) empfängt.

17. Vorrichtung nach einem der Ansprüche 1 bis 3 und 5 bis 12, **dadurch gekennzeichnet, dass** für ein primäres Abtastelement (200), das keinen expliziten Eingang für ein Haltesignal "hold" umfasst, das "hold logic" Modul (260) einen ersten NAND-Port (564) und einen zweiten NAND-Port (565) enthält, der erste NAND-Port (564) an einem ersten Eingang das erste Taktsignal (105a) und an einem zweiten Eingang den Ausgang des zweiten NAND-Ports (565) empfängt.

18. Vorrichtung nach einem der Ansprüche 15, 16 und 17, **dadurch gekennzeichnet, dass** sie einen AND-Port (561, 563) oder einen NAND-Port (565) umfasst, wobei einer der Eingänge der Ports entsprechend dem "Reset"-Signal (104) auf dem logischen Wert 0 gesperrt wird.

19. Vorrichtung nach einem der Ansprüche 1 bis 12, **dadurch gekennzeichnet, dass** wenigstens ein Teil der primären (100, 200) und/oder sekundären (110) Abtastelemente zum Aktualisieren ihres Zustands an der abfallenden Flanke des Taktsignals (105a, 105b) ausgelegt sind.

20. Vorrichtung nach einem der Ansprüche 1 bis 3 und 5 bis 12, **dadurch gekennzeichnet, dass** wenigstens ein Teil der primären (100, 200) und/oder sekundären (110) Abtastelemente zum Aktualisieren ihres Zustands auf dem hohen oder tiefen Pegel des Taktsignals (105a, 105b) ausgelegt sind.

## Claims

1. A device for testing and monitoring digital circuits enabling the detection of timing faults affecting a signal D received directly at the input of a flip-flop called primary sampling element (100, 200), said primary sampling element supplying a first value D₁ of the signal D and receiving a first clock signal (105a) for its updating, said testing and monitoring device **characterized in that** it comprises at least:
• a scan logic module (120) introducing a latency in the signal D, said scan logic module (120) having a first input receiving the signal "D", a second input receiving a "scan in" signal and a third input receiving a "scan enable" signal (103) suitable for selecting the operating mode of the testing and monitoring device in a scan mode or an operational mode, an output (120s) linked to a secondary sampling element (110) of the signal D and supplying a second sampled signal D₂ of the signal D after passing through the scan logic module, said secondary sampling element (110) receiving a second clock signal (105b) for updating its state,
• a module (150) for comparison of the signal D₁ and the signal D₂ generating an alert or error signal.

2. The device as claimed in claim 1, **characterized in that** it comprises a module supplying a "reset" signal (112) to said primary sampling element (100).

3. The device as claimed in claim 2, **characterized in that** the module supplying a "reset" signal to the primary sampling element comprises two NAND gates (130) and (140) adapted to allow a selective "reset" in scan mode and a normal "reset" in operational mode.

4. The device as claimed in claim 2, **characterized in that** the module supplying a "reset" signal to the primary sampling element comprises a NAND gate (140) with a first input receiving a reset signal (104) and a second input (113) receiving the inverted output signal of the secondary sampling element "scan out" (106) and **in that** the primary sampling element (100') is chosen so that its state is forced to the value logic 1 as soon as the "scan enable" signal (103) takes the value logic 1.

5. The device as claimed in one of claims 1 to 3, **characterized in that** it comprises a module (160, 260) suitable for generating a signal for controlling the holding of the state of said primary sampling element (100, 200).

6. The device as claimed in one of claims 1 to 5, **characterized in that** the first clock signal (105a) and the second clock signal (105b) are identical.

7. The device as claimed in one of claims 1 to 6, **characterized in that** the assembly formed by said secondary sampling element (110) and the "scan logic" module (120) form a scan flip-flop.

8. The device as claimed in one of claims 1 to 7, **characterized in that** it comprises an XOR gate (150) used to compare the versions of the signal "D" sampled by said primary sampling element (100, 200) and by said secondary sampling element (110).

9. The device as claimed in one of claims 1 to 8, **characterized in that** it comprises an inverter (270) on the path of the second clock signal (105b).

10. The device as claimed in one of claims 1 to 9, **characterized in that** it comprises a timing element arranged on the path of the first clock signal (105a) arriving at the primary sampling element and/or a timing element arranged on the path of the second clock signal (105b) arriving at the secondary sampling element (110).

11. The device as claimed in one of claims 1 to 10, **characterized in that** the "scan logic" module (120) cormpises a multiplexer (320) controlled by the "scan enable" signal (103).

12. The device as claimed in one of claims 1 to 11, **characterized in that** the "scan logic" module (120) cormprises an XNOR gate (322), a NOR gate (323) and a NAND gate (321) or an XOR gate, a NOR gate (323) and a NAND gate (321).

13. The device as claimed in one of claims 1 to 3 and 5 to 12, **characterized in that** for a primary sampling element (100) comprising an explicit input for a hold signal "hold", the "hold logic" module (160) is composed of a NAND gate (460) whose "scan enable" (103) and "hold" (109) inputs are inverted.

14. The device as claimed in one of claims 1 to 3 and 5 to 12, **characterized in that** for a primary sampling element (100) comprising an explicit input for a hold signal "hold", the "hold logic" module (160) is composed of two NAND gates (461, 462) whose "hold" input (109) is inverted.

15. The device as claimed in one of claims 1 to 3 and 5 to 12, **characterized in that** for a primary sampling element (200) not including an explicit input for a hold signal "hold", the "hold logic" module (260) is composed of a NOR gate (560) receiving the clock signal (105a) and the "scan enable" signal (103) as input.

16. The device as claimed in one of claims 1 to 3 and 5 to 12, **characterized in that** for a primary sampling element (200) not including an explicit input for a hold signal "hold", the "hold logic" module (260) is composed of a NOR gate (560, 562) and an AND gate (561, 563), the NOR gate (560, 562) receives the clock signal (105a) on a first input and the output of the AND gate (563) on a second input.

17. The device as claimed in one of claims 1 to 3 and 5 to 12, **characterized in that** for a primary sampling element (200) not including an explicit input for a hold signal "hold", the "hold logic" module (260) contains a first NAND gate (564) and a second NAND gate (565), the first NAND gate (564) receives the first clock signal (105a) on a first input and the output of the second NAND gate (565) on a second input.

18. The device as claimed in one of claims 15, 16 and 17 **characterized in that** it comprises an AND gate (561, 563) or a NAND gate (565), one of the inputs of said gates corresponding to the "reset" signal (104) is blocked at the value logic 0.

19. The device as claimed in one of claims 1 to 12, **characterized in that** at least some of the primary (100, 200) and/or secondary (110) sampling elements are suitable for updating their state on the falling edge of the clock signal (105a, 105b).

20. The device as claimed in one of claims 1 to 3 and 5 to 12, **characterized in that** at least some of the primary (100, 200) and/or secondary (110) sampling elements are adapted for updating their state on the high or low level of the clock signal (105a, 105b).
